# EUROPEAN PATENT APPLICATION

(11) **EP 3 690 957 A1**
(43) Date of publication of application: **05.08.2020**
(21) Application number: 19155044.1
(22) Date of filing: 01.02.2019
(51) Int. Cl.: H01L 29/861, H01L 21/329, H01L 29/16, H01L 29/739, H01L 29/872

(54) **PASSIVATION LAYER FOR SPARK PREVENTION**

(71) Applicant: ABB Schweiz AG, 5400 Baden (CH)
(72) Inventor: BELLINI, Marco, 8952 Schlieren (CH); KNOLL, Lars, 5512 Wohlenschwil (CH)
(74) Representative: Kuhnen & Wacker Patent- und Rechtsanwaltsbüro PartG mbB

(57) **Abstract**

A power semiconductor device (2) comprises a silicon carbide (SiC) layer (101), the SiC layer (101) having a first main side (102) and a second main side (103) opposite to the first main side (102), wherein the SiC layer (101) has an active region (AR) and a termination region (TR) surrounding the active region (AR) in an orthogonal projection onto a plane parallel to the first main side (102), and a passivation layer (10) is located on the first main side (101) to cover at least a portion of the termination region (TR), characterized in that the passivation layer (20) has a thickness (d) perpendicular to the first main side (102) of at least 5 µm. The passivation layer (20) is a patterned layer having a trench formed therein, the trench extending in a direction perpendicular to the first main side (102) and surrounding the active region (AR) in the orthogonal projection.

## Description

### FIELD OF THE INVENTION

The present invention relates to power semiconductor device according to the preamble of claim 1 and to a method for manufacturing such power semiconductor device.

### BACKGROUND OF THE INVENTION

Power semiconductor devices using silicon carbide (SiC) benefit from a high critical electric field of 3 MV/cm due to the large energy bandgap of about 3.26 eV. Another advantage of SiC compared to other semiconductor materials such as silicon (Si) for power semiconductor device applications is the high thermal conductivity in the range of 3 to 3.8 W/(cmK).

SiC enables power semiconductor devices with very high blocking voltages with a relatively small thickness of the SiC layer (about 100 µm for a nominal blocking voltage of 10kV).

Edge terminations are designed to avoid field crowding effects that cause premature breakdown. A number of different edge termination techniques have been applied so far, such as floating field rings, junction termination extension (JTE), and multi-step etched JTE. The aim of all these edge termination techniques is to shift and to reduce the peak field to where it can do least harm to device performance and reliability.

The corresponding edge termination for a SiC based power semiconductor device could be theoretically quite small. For example a JTE edge termination may require a lateral width of only 230 µm for a nominal blocking voltage of 12kV (which would corresponds to 95% efficiency of the maximum theoretical value for a one-dimensional model.

However actual demonstrated devices show much larger terminations or distances of the active region to the edge of the chip because the air and the packaging material cannot withstand such high electric fields due to large variations of the electric potential in such small distances.

From the article "Polyimide Passivation Effect on High Voltage 4H-SiC PiN Diode Breakdown Voltage" by Sombel Diaham et al., Materials Science Forum Vols. 615-617 (2009) pp. 695-698, it is known to use a polyimide layer having a thickness of 4 µm or alternatively to use a silicon oxide layer having a thickness of 1.8 µm as a passivation layer covering a planar termination region of a SiC based power semiconductor device.

In US 2010/0314629 A1 it is disclosed a silicon carbide semiconductor device that comprises a termination end-portion provided for electric-field relaxation in the perimeter of a cell portion driven as a semiconductor element, wherein the termination end-portion is provided with an inorganic protection film having high heat resistance that is formed on an exposed surface of a well region as a first region formed on a side of the cell portion, and an organic protection film having a high electrical insulation capability with a little influence by electric charges that is formed on a surface of an electric-field relaxation region formed in contact relation to an outer lateral surface of the well region and apart from the cell portion, and on an exposed surface of the silicon carbide layer.

### SUMMARY OF THE INVENTION

In view of the above disadvantages in the prior art it is an object of the invention to provide a SiC based power semiconductor device with improved device performance and improved reliability including an improved prevention of sparks during operation of the power semiconductor device.

The object is attained by a power semiconductor device according to claim 1. Further developments of the invention are specified in the dependent claims.

The power semiconductor device of the invention comprises a silicon carbide layer, the silicon carbide layer having a first main side and a second main side opposite to the first main side, wherein the silicon carbide layer has an active region and a termination region surrounding the active region in an orthogonal projection onto a plane parallel to the first main side, and a passivation layer is located on the first main side to cover at least a portion of the termination region. The passivation layer has a thickness in a direction perpendicular to the first main side of at least 5 µm. Having a passivation layer of such thickness of at least 5 µm increases the spark distance and can avoid sparks thereby in a more reliable manner compared to a device having a thinner passivation layer, without having to increase the lateral width of the termination area.

The passivation layer is a patterned layer having at least one trench formed therein, the at least one trench extending in a direction perpendicular to the first main side, and the at least one trench surrounding the active region in the orthogonal projection onto the plane parallel to the first main side. The at least one trench makes the thick passivation layer less susceptible to cracking. In an exemplary embodiment the power semiconductor device comprises a plurality of the trenches in the passivation layer, which is an even more effective means for prevention of cracking.

In an exemplary embodiment the thickness of the passivation layer is at least 10 µm or at least 20 µm. The higher the thickness of the passivation layer the more reliable is the prevention of sparks.

In an exemplary embodiment, the material of the passivation layer is spin-on glass. Spin-on glass can be deposited easily with the required large thickness, has suitable passivation and electrical isolation properties.

In an exemplary embodiment the trenches separate the passivation layer in plural rings, at least an outer side of each ring respectively surrounding the active region in the orthogonal projection onto the plane parallel to the first main side, wherein the innermost ring of the passivation layer has a largest lateral width, the lateral width of each ring being defined as a shortest lateral distance between an inner side and the outer side of the respective ring in the orthogonal projection onto the plane parallel to the first main side, wherein the inner side of a ring is the lateral side of that ring facing towards the active region and the outer side of a ring is the lateral side of that ring facing away from the active region.

In an exemplary embodiment each trench has a depth of at least 50 % of a passivation layer thickness. A depth of at least 50% of the passivation layer thickness can prevent cracking of the passivation layer. In an exemplary embodiment each trench penetrates through the passivation layer, i.e. the depth of each trench has at least the same depth as the thickness of the passivation layer at positions adjacent to the respective trench. This can prevent cracking of the passivation layer most efficiently.

The power semiconductor device of the invention may be manufactured by a method according to claim 8. It comprises the following steps:
(a) providing a silicon carbide layer having a first main side and a second main side opposite to the first main side, wherein the silicon carbide layer has an active region and an termination region surrounding the active region in an orthogonal projection onto a plane parallel to the first main side;
(b) forming a passivation material layer on the first main side to cover at least a portion of the termination region; and
(c) patterning the passivation material layer to form at least one trench in the passivation material layer and to thereby form a patterned passivation layer that has a thickness in a direction perpendicular to the first main side of at least 5 µm, wherein the at least one trench extends in a direction perpendicular to the first main side, and wherein the at least one trench surrounds the active region in the orthogonal projection onto the plane parallel to the first main side.

In an exemplary embodiment the passivation layer is formed by any one of plasma enhanced chemical vapor deposition (PECVD), low pressure chemical vapor deposition (LPCVD), atomic layer deposition (ALD), or a spin-on process such as a spin-on glass (SOG) process. The spin-on process facilitates to deposit a thick passivation layer in an easy and cost-efficient manner. Specifically, the spin-on glass process allows to deposit a thick silicon oxide passivation layer. The other deposition methods are also suitable to deposit a thick passivation layer of a variety of different passivation materials.

In an exemplary embodiment the passivation material layer is formed in step (b) to cover the whole first main side of the silicon carbide layer.

In an exemplary embodiment the silicon carbide layer provided in step (a) has plural active regions and plural termination regions, each termination region surrounding a corresponding one of the plural active regions in an orthogonal projection onto a plane parallel to the first main side. In step (b) the passivation material layer is formed on the first main side to cover at least a portion of each termination region. In step (c) plural trenches are formed in the passivation material layer, wherein each active region is surrounded by at least one of the trenches in the orthogonal projection onto the plane parallel to the first main side, and wherein a separation area without the passivation layer on the first main side separates the plural termination regions from each other. The method according to this exemplary embodiment comprises further a step of dicing the silicon carbide layer into plural silicon carbide dies after the step (c) along dicing lines extending in the separation area. During dicing the silicon carbide layer the passivation layer is stressed, which can easily result in cracking of the thick passivation layer. In the method of the before mentioned exemplary embodiment the trenches respectively surrounding the active regions can prevent the thick passivation layer from cracking when the silicon carbide layer is diced into plural silicon carbide dies.

In an exemplary embodiment each active region is surrounded by plural ring-shaped trenches in the orthogonal projection onto the plane parallel to the first main side. Plural trenches surrounding each active region can prevent the thick passivation layer most efficiently from cracking.

Therein the plural trenches surrounding each active region may separate the passivation layer in plural rings, wherein at least an outer side of each ring respectively surrounds a respective active region in the orthogonal projection onto the plane parallel to the first main side. An innermost ring of the passivation layer surrounding the respective active region has a larger lateral width than the lateral width of all other rings surrounding that respective active region, wherein the lateral width of each ring is defined as a shortest lateral distance between an inner side and the outer side of the respective ring in the orthogonal projection onto the plane parallel to the first main side, wherein the outer side of any ring is the lateral side of that ring facing towards the respective active region and the inner side of a ring is the lateral side of that ring facing away from the respective active region. In this exemplary embodiment the distance of the trenches is less in an area close to the dicing lines. Accordingly, prevention of cracking of the passivation layer during dicing can be most efficient.

In an exemplary embodiment the method comprises a step of forming plural walls or pillars of a polyimide material on the first main side before the step (b) of forming the passivation material layer on the first main side, wherein the passivation material layer is formed in step (b) by a spin-on process, and wherein the walls or pillars are embedded into the passivation material layer in the step (b) of forming the passivation material layer. The walls or pillars of polyimide material have the technical effect to make the passivation material deposited by the spin-on process to be more smooth or flat.

In an exemplary embodiment the walls or pillars are removed in the step (c) of patterning the passivation material layer.

### BRIEF DESCRIPTION OF THE DRAWINGS

Detailed embodiments of the invention will be explained below with reference to the accompanying figures, in which:
- Fig. 1: shows a cross-section of a power semiconductor device according to a first embodiment taken along line A-A' in Fig. 2;
- Fig. 2: shows a top view of the power semiconductor device of Fig. 1;
- Fig. 3A to 3E: illustrate method steps of a method for manufacturing the power semiconductor device of Figs. 1 and 2; and
- Figs. 4A and 4B: illustrate a modification of the method illustrated in Figs. 3A to 3E.

The reference signs used in the figures and their meanings are summarized in the list of reference signs. Generally, similar elements have the same reference signs throughout the specification. The described embodiments are meant as examples and shall not limit the scope of the invention.

### DETAILED DESCRIPTION OF EXEMPLARY EMBODIMENTS

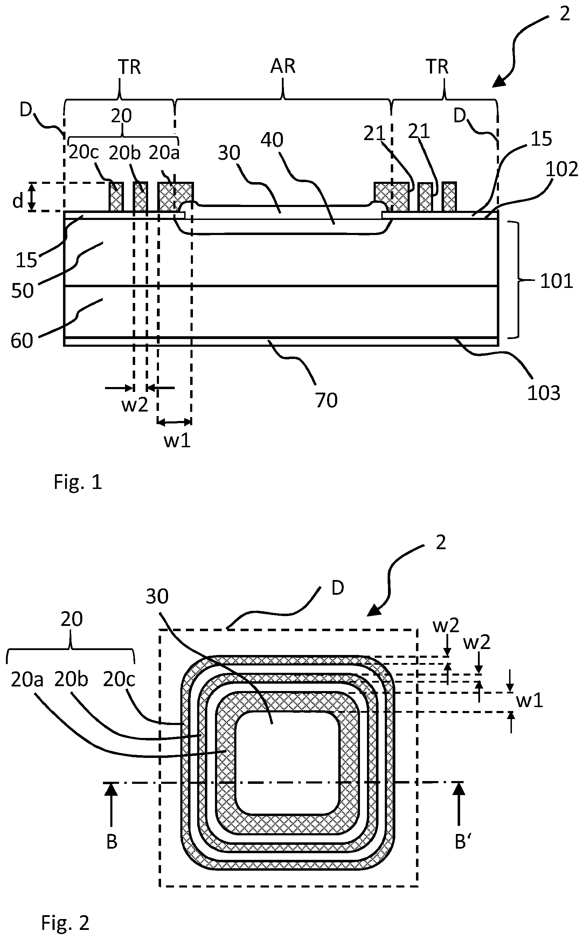

In the following a power semiconductor device 2 according to an embodiment is described with reference to Figs. 1 and 2. Fig. 2 shows as top view of the power semiconductor device 2, and Fig. 1 shows a cross-section of the power semiconductor device 2 taken along line B-B' in Fig. 2.

The power semiconductor device 2 according to the embodiment is a power diode. It comprises a silicon carbide layer 101 having a first main side 102 and a second main side 103 opposite to the first main side 102. The silicon carbide layer 101 has an active region AR and a termination region TR surrounding the active region AR in an orthogonal projection onto a plane parallel to the first main side 102. A passivation layer 20 is located on the first main side 102 to cover at least a portion of the termination region TR. The passivation layer 20 has a thickness in a direction perpendicular to the first main side 102 of at least 5 µm, exemplarily of at least 10 µm or more exemplarily of at least 20 µm. A material of the passivation layer 20 may be silicon oxide such as a spin-on glass (SOG). Alternatively, the passivation layer 20 may be of any other material suitable for electrical isolation and passivation purposes. Exemplarily, the material of the passivation layer 20 is a material that can be deposited by a spin-on process (such as spin-on insulators, spin-on nitrates or spin-on polymers). The spin-on process allows to deposit the passivation layer 20 with a large thickness. Specifically, the spin-on glass process facilitates to deposit a thick silicon oxide layer as the passivation layer.

The silicon carbide layer 101 comprises in an order from the first main side 102 to the second main side 103 a p-type anode layer 40, an n⁻-type drift layer 50 and an n-type substrate layer 60 to form a PiN structure. The anode layer 40 is located in the active region AR, whereas the drift layer 50 and the substrate layer 60 extend laterally in both, in the termination region TR and also in the active region AR. On the first main side 102 there is arranged a first main electrode 30 (which functions as an anode electrode in the power diode of the present embodiment) to be in direct contact with the anode layer 40. As can be seen best from Fig. 1 the passivation layer 20 overlaps the first main electrode 30.

On the second main side 103 there is arranged a second main electrode 70 (which functions as a cathode electrode in the power diode of the present embodiment) as a continuous metallization layer being in direct contact with the substrate layer 60. A thin surface passivation layer 15 is formed on the silicon carbide layer 101 to cover the first main side 102 of the silicon carbide layer 101 in the whole termination region TR and to overlap with the anode layer 40 in an orthogonal projection onto a plane parallel to the first main side 102. The surface passivation layer 15 has a thickness of exemplarily less than 2 µm or exemplarily less than 1 µm. The surface passivation layer 15 may be formed of a material different from that of the thick passivation layer 20. Exemplarily aluminum oxide (Al₂O₃), calcium fluoride (CaF₂), hafnium oxide (HfO₂), lithium fluoride (LiF), silicon nitride (Si₃N₄), silicon dioxide (SiO₂), titanium dioxide (TiO₂), zirconium dioxide (ZrO₂), titanium dioxide (TiO₂) may be used as a material for the surface passivation layer 15. It is also possible to use a stack of layers of different materials or combinations of the before mentioned materials for the surface passivation layer 15.

The silicon carbide layer 101 may be a silicon carbide wafer or a silicon carbide die. In the latter case the circumferential edge of the silicon carbide layer 101 may be a dicing line D.

Plural trenches 21 are formed in the passivation layer 20. Each trench 21 in the passivation layer 20 extends from a top side of the passivation layer 20, which is a side of the passivation layer opposite to the silicon carbide layer 101, into the passivation layer 20 in a direction perpendicular to the first main side 102. Each trench 21 penetrates through the passivation layer 20 so that the surface passivation layer 15 is exposed at the bottom of the trenches 21, respectively. As illustrated in the top view shown in Fig. 2 each trench 21 surrounds the active region AR in an orthogonal projection onto a plane parallel to the first main side 102 so that the trenches 21 separate the passivation layer 20 into plural rings 20a, 20b and 20c. The outer sides of each ring 20a, 20b and 20c facing away from the active region AR respectively surround the active area AR. An innermost ring 20a which is closest to the active region AR overlaps the anode layer 40 and the first main electrode 30 in an orthogonal projection onto a plane parallel to the first main side 102. Accordingly, the innermost ring 20a extends into the area of the active region AR in the orthogonal projection onto the plane parallel to the first main side 102. All remaining rings 20b, 20c of the passivation layer 20 laterally surround the active region, i.e. surround the active region AR in the orthogonal projection onto the plane parallel to the first main side 102. The innermost ring 20a has larger lateral width w1 than the lateral width w2 of all other rings 20b, 20c. Therein the, the lateral width w1, w2 of each ring 20a, 20b, 20c is defined as a shortest lateral distance between its inner side and its outer side in the orthogonal projection onto the plane parallel to the first main side 102, wherein the outer side of a ring is a lateral side of that ring 20a, 20b, 20c facing towards the active region AR and the inner side of a ring 20a, 20b, 20c is a lateral side of that ring facing away from the active region AR.

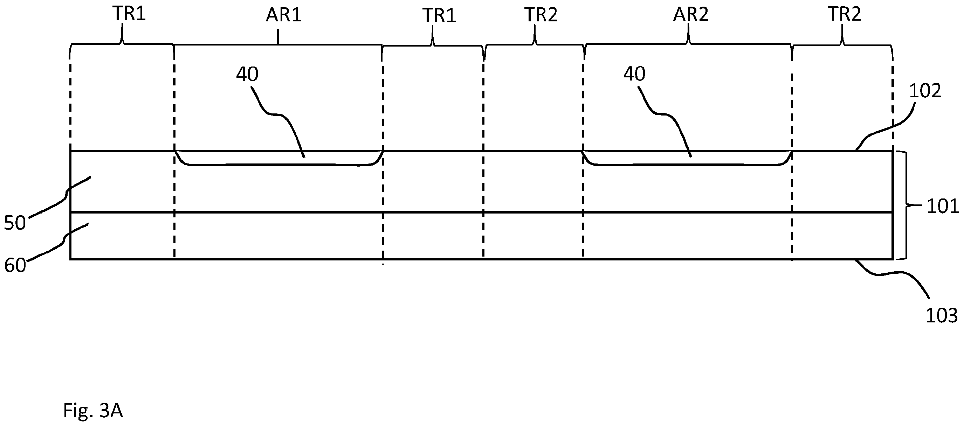

In the following there will be described an embodiment of the method for manufacturing the power semiconductor device 2 with reference to Figs. 3A to 3E. Therein, reference signs used in Figs. 5A to 5F, which are identical to the reference signs used in Figs. 1 and 2 refer to elements having the same characteristics and properties. It is therefore referred to the above description of these elements for further details.

In a first method step a silicon carbide layer 101 having a first main side 102 and a second main side 103 opposite to the first main side 102 is provided as illustrated in Fig. 3A. The silicon carbide layer 101 has plural active regions AR1, AR2 and plural termination regions TR1, TR2, each termination region TR1, TR2 surrounding a corresponding one of the plural active regions AR1, AR2 in an orthogonal projection onto a plane parallel to the first main side 102. In Fig. 3A there are illustrated two active regions AR1, AR2 of the plural active regions and two corresponding termination regions TR1, TR2 of the plural termination regions. In each active region AR1, AR2 and its surrounding termination region TR1, TR2 the silicon carbide layer 101 comprises in an order from the first main side 102 to the second main side 103 a p-type anode layer 40, an n⁻-type drift layer 50 and an n-type substrate layer 60, which form a PiN structure. The anode layer 40 is located in the active region AR, respectively, whereas the drift layer 50 and the substrate layer 60 extend laterally throughout the whole silicon carbide layer 101 in all active regions AR1, AR2 and all termination regions TR1, TR2. In other words, the drift layer 50 and the substrate layer 60 are shared by all active regions AR1, AR2 and all termination regions TR1, TR2 in the silicon carbide layer 101.

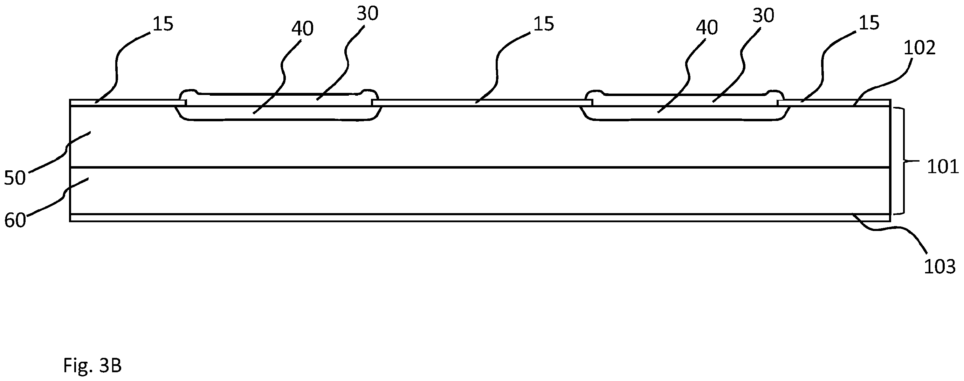

In a next method step illustrated in Fig. 3B a thin surface passivation layer 15 is formed on the first main side 102 to cover the termination regions TR1 and TR2. In addition, the surface passivation layer 15 extends into the active region to overlap with the circumferential edge of the anode layer 40 in each active region AR1, AR2 in an orthogonal projection onto a plane parallel to the first main side 102. Alternatively, the thin surface passivation layer 15 may be formed before forming the anode layer 40. After forming the surface passivation layer 15, a first main electrode 30 is deposited onto the silicon carbide layer 101 in each active region AR1, AR2 to directly contact the anode layer 40 in each active region AR1, AR2. With regard to a detailed description of the material and the thickness of the surface passivation layer 15 it is referred to the description of the power semiconductor device 2 above

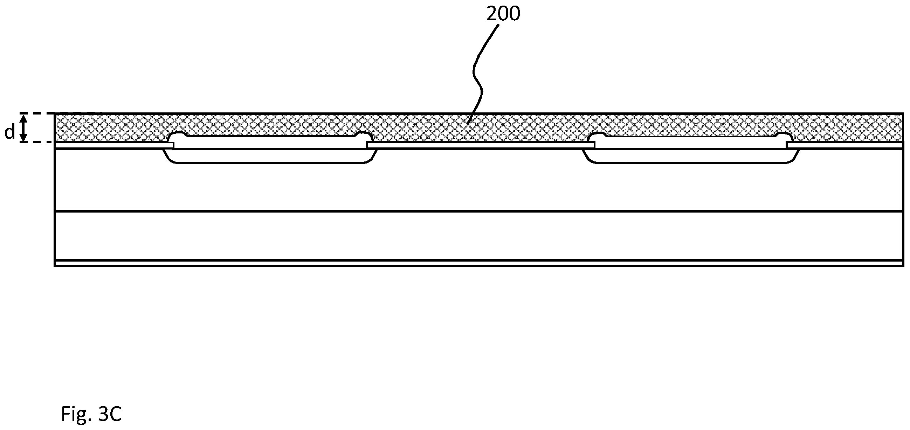

In a next method step illustrated in Fig. 3C a continuous passivation material layer 200 is formed on the whole first main side 102 of the silicon carbide layer 101, namely on the surface passivation layer 15 and on the first main electrode 40. Exemplarily, the continuous layer passivation material layer 200 may be deposited by any one of a spin-on process, such as a spin-on glass (SOG) process, a plasma enhanced chemical vapor deposition (PECVD), a low pressure chemical vapor deposition (LPCVD), or an atomic layer deposition (ALD). The passivation material layer 200 may be made of any one of the materials discussed above as materials of the passivation layer 20.

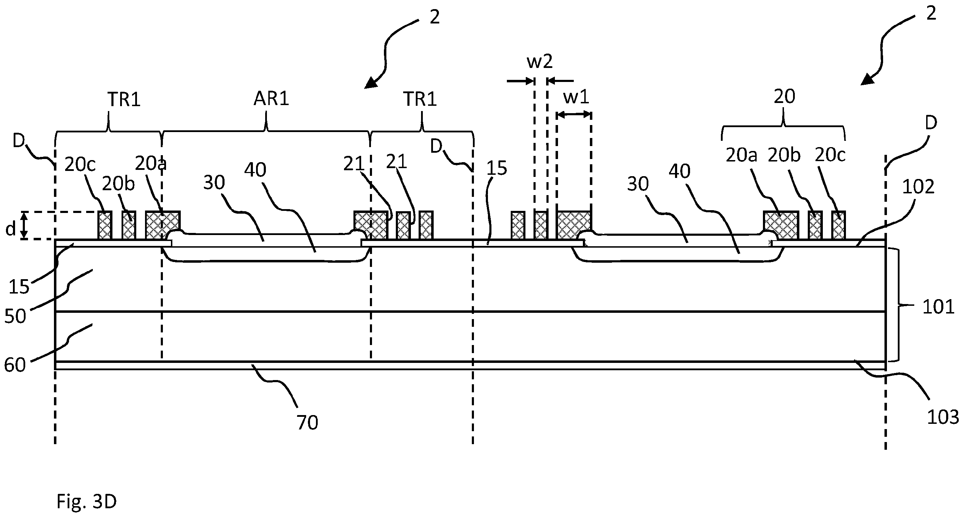

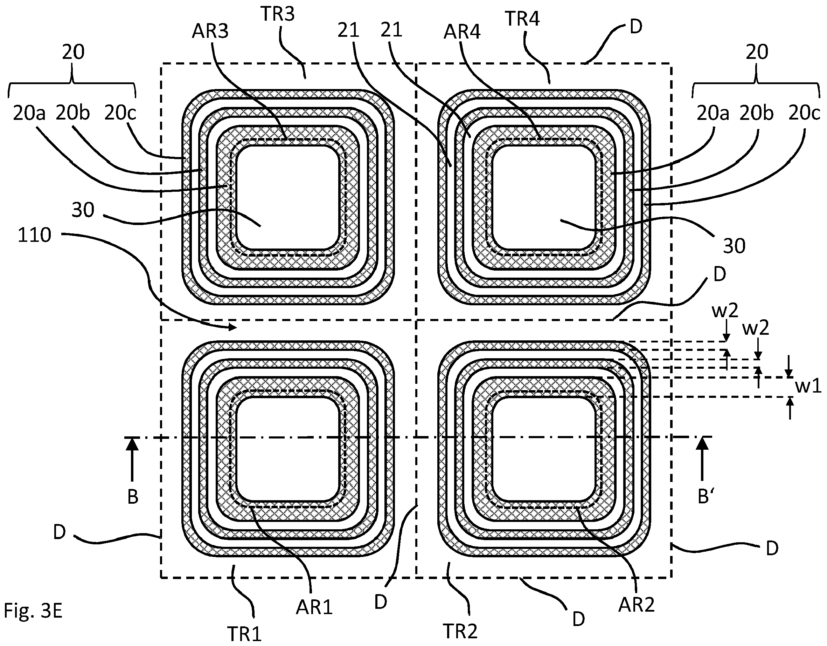

In a subsequent method step illustrated in Fig. 3D the continuous layer of passivation material layer 200 is patterned or structured, e.g. by well-known lithography techniques. The patterned passivation layer 20 resulting from the patterning of the passivation material layer 200 covers at least a portion of each termination region TR1, TR2. Plural trenches 21 are formed in the patterning of the passivation material layer 200. Each active region AR1, AR2 is surrounded by at least one of the trenches 21 in the orthogonal projection onto the plane parallel to the first main side 102 as shown in the top view of Fig. 3E. After patterning the continuous passivation material layer 200, a separation area 110 without any passivation layer 20 on the first main side 102 surrounds and separates the plural active regions AR1-AR4 from each other as shown in Fig. '3E.

Each active region AR is surrounded by plural ring-shaped trenches 21 in the orthogonal projection onto the plane parallel to the first main side 102. Each trench 21 penetrates through the passivation layer 20.

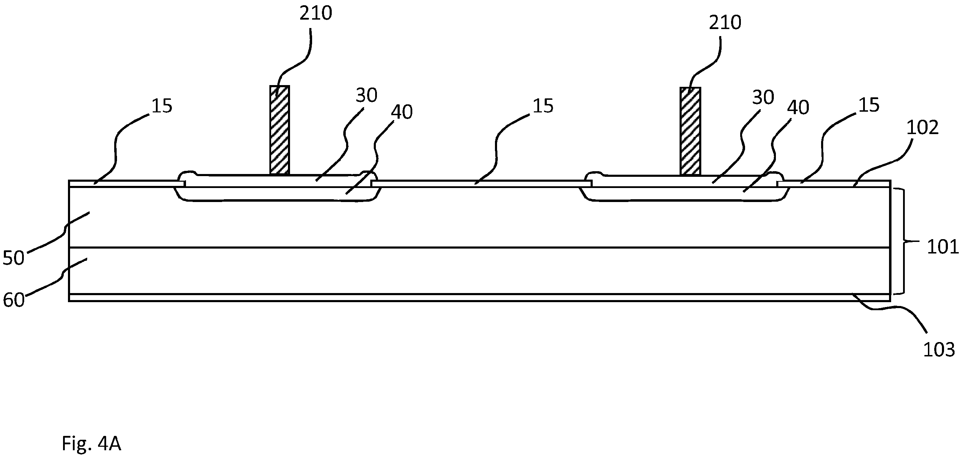

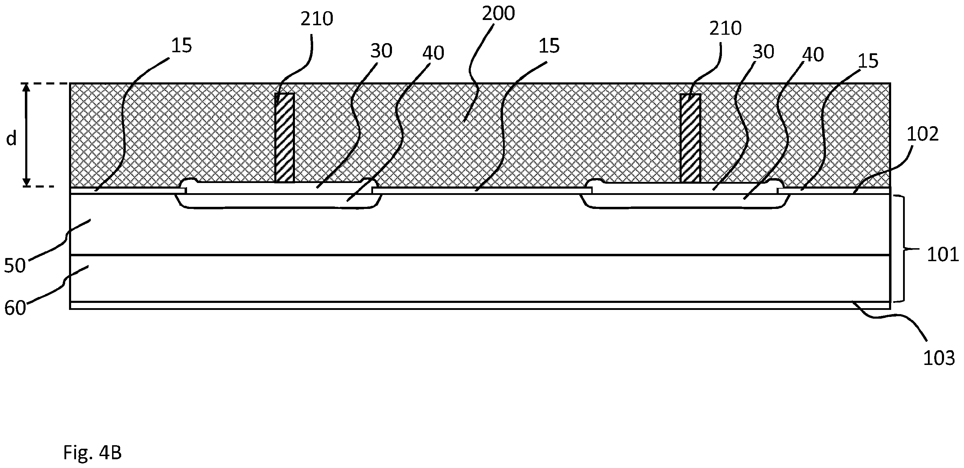

The method further comprises a step of dicing the silicon carbide layer 101, the surface passivation layer 15 and the second main electrode 70 into plural dies along dicing lines D extending in the separation area 110. During dicing a stress applied to the passivation layer 20 does not result in cracking of the brittle passivation layer 20 because the trenches 21 make the passivation layer 20 as a whole more flexible. After dicing plural power semiconductor devices 2 as discussed above with reference to Figs. 3 and 4 are obtained.

A modification of the method discussed above with reference to Figs. 3A to 3E is illustrated in Figs. 4A and 4B. The modified embodiment illustrated in Figs. 4A and 4B differs from the embodiment discussed above with reference to Figs. 3A to 3E in that before the step of forming the continuous passivation material layer 200 plural pillars or wall elements are formed no the first main side 102. In the exemplary embodiment two pillars are formed on the first main side electrode 30 on each active region AR. However, the pillars or walls may also be formed in other areas of the silicon carbide layer 101. Thereafter the walls or pillars 210 are embedded into the passivation material layer 200 in the step of forming the passivation material layer 200 as is illustrated in Fig. 4B. All remaining method steps are the same as discussed above with reference to Figs. 3A to 3E. The walls or pillars 210 facilitate forming a more smooth or flat passivation material layer 200. This is in particular true if the passivation material layer 200 is formed by spin-on process. The modified embodiment is in particular advantageous for a thick passivation layer 20 having a thickness d above 10 µm or above 20 µm. Exemplarily the walls or pillars 210 may be formed from a polyimide layer that is structured or patterned in a way known by a person skilled in the art.

It will be apparent for persons skilled in the art that modifications of the above described embodiment are possible without departing from the scope of the invention as defined by the appended claims.

In the above described embodiment the passivation layer 20 was described to have plural trenches 21 and shown in the figures with two trenches 21 between pairs of adjacent rings 20a, 20b and 20c. However, the power semiconductor device 2 may include only two rings and only one trench between these two rings. On the other side there may be more than three rings and more than only two trenches.

Also, in the above embodiment the innermost ring 20a was described to have the largest lateral width w1, whereas the remaining rings had all the same lateral width w2. In a modified embodiment, all rings 20a, 20b, 20c may have the same or different lateral widths w1, w2. Also in a case where the innermost ring 20a has the largest lateral width w1, the width w2 of the remaining rings 20b, 20c is not necessarily the same.

Moreover, in the embodiment described above with reference to Figs. 1 and 2 as well as in the method described with reference to Figs. 3A to 3E the trenches 21 were described to penetrate through the passivation layer 20. However, the trenches may not fully penetrate through the passivation layer but may have a depth which is at least 50 % of the layer thickness d of the passivation layer 20.

The above described power semiconductor device 2 is a power diode having a PiN structure. However, the power semiconductor device of the invention may be any SiC based vertical power semiconductor device that has a termination region TR surrounding an active region AR. The power semiconductor device of the invention may for example be a junction barrier Schottky (JBS) diode, an insulated gate bipolar thyristor (IGBT) an integrated gate commutated thyristor (IGCT), a phase controlled thyristor (PCT) or any other vertical power semiconductor device where a high voltage may be applied between a first and a second main side of a SiC layer 101.

Likewise, in the above embodiment the n-type layers may be switched with p-type layers and the p-type layers may be switched with n-type layers, i.e. in the above described embodiments the anode layer 40 may be a n-type layer and the drift layer 50 and the substrate layer 60 may be p-type layers.

In the modified embodiment discussed with Figs. 4A and 4B the walls or pillars 210 were formed in areas in which they are removed together with portions of the passivation material layer 200 in the step of patterning the passivation material layer 200. Alternatively, the walls or pillars may be formed in areas where they are embedded in the passivation layer 20, i.e. where they are not removed in the step of patterning the passivation material layer 200.

It should be noted that the term "comprising" does not exclude other elements or steps and that the indefinite article "a" or "an" does not exclude the plural. Also elements described in association with different embodiments may be combined.

### List of reference signs

- 2: power semiconductor device
- 20: passivation layer
- 15: surface passivation layer
- 20a, 20b, 20c: ring
- 21: trench
- 30: first main electrode
- 40: anode layer
- 50: drift layer
- 60: substrate layer
- 70: second main electrode
- 101: silicon carbide layer
- 102: first main side
- 103: second main side
- 110: separation area
- 200: passivation material layer
- 210: wall or pillar
- AR, AR1-AR4: active region
- D: dicing line
- TR, TR1-R4: termination region
- d: thickness
- w1, w2: lateral width

## Claims

1. A power semiconductor device comprising a silicon carbide layer (101), the silicon carbide layer (101) having a first main side (102) and a second main side (103) opposite to the first main side (102), wherein
the silicon carbide layer (101) has an active region (AR) and a termination region (TR) surrounding the active region (AR) in an orthogonal projection onto a plane parallel to the first main side (102), and
a passivation layer (20) is located on the first main side (101) to cover at least a portion of the termination region (TR),
**characterized in that** the passivation layer (20) has a thickness (d) in a direction perpendicular to the first main side (102) of at least 5 µm, and
the passivation layer (20) is a patterned layer having at least one trench (21) formed therein, the at least one trench (21) extending in a direction perpendicular to the first main side (101), and the at least one trench (21) surrounding the active region (AR) in the orthogonal projection onto the plane parallel to the first main side (101).

2. The power semiconductor device according to claim 1, wherein the thickness (d) of the passivation layer (20) is at least 10 µm or at least 20 µm.

3. The power semiconductor device according to claim 1 or 2, wherein the material of the passivation layer (20) is spin-on glass.

4. The power semiconductor device according to any one of claims 1 to 3, comprising a plurality of the trenches (21) in the passivation layer (20).

5. The power semiconductor device according to claim 4, wherein the trenches (21) separate the passivation layer (20) in plural rings (20a, 20b, 20c), at least an outer side of each ring (20a, 20b, 20c) respectively surrounding the active region (AR) in the orthogonal projection onto the plane parallel to the first main side (102), wherein the innermost ring (20a) of the passivation layer (20) has a largest lateral width (w1), the lateral width (w1, w2) of each ring (20a, 20b, 20c) being defined as a shortest lateral distance between an inner side and the outer side of the respective ring (20a, 20b, 20c) in the orthogonal projection onto the plane parallel to the first main side (102), wherein the inner side of a ring (20a, 20b, 20c) is the lateral side of that ring (20a, 20b, 20c) facing towards the active region (AR) and the outer side of a ring (20a, 20b, 20c) is the lateral side of that ring facing away from the active region (AR).

6. The power semiconductor device according to any one of claims 1 to 5, wherein each trench (21) has a depth of at least 50 % of the thickness (d) of the passivation layer (20).

7. The power semiconductor device according to any one claims 1 to 6, wherein each trench (21) penetrates through the passivation layer (20).

8. A method for manufacturing the power semiconductor device according to any one claims 1 to 7, the method comprising the following steps:
(a) providing a silicon carbide layer (101) having a first main side (102) and a second main side (103) opposite to the first main side (102), wherein the silicon carbide layer (101) has an active region (AR) and an termination region (TR) surrounding the active region (AR) in an orthogonal projection onto a plane parallel to the first main side (102);
(b) forming a passivation material layer (200) on the first main side (102) to cover at least a portion of the termination region (TR); and
(c) patterning the passivation material layer (200) to form at least one trench (21) in the passivation material layer (200) and to thereby form a patterned passivation layer (20) that has a thickness (d) in a direction perpendicular to the first main side (102) of at least 5 µm, wherein the at least one trench (21) extends in a direction perpendicular to the first main side (102), and wherein the at least one trench (21) surrounds the active region (AR) in the orthogonal projection onto the plane parallel to the first main side (101).

9. The method according to claim 8, wherein the passivation material layer (200) is formed by any one of plasma enhanced chemical vapor deposition (PECVD), low pressure chemical vapor deposition (LPCVD), atomic layer deposition (ALD), or a spin-on process, exemplarily by a spin-on glass (SOG) process.

10. The method according to claim 8 or 9, wherein the passivation material layer (200) is formed in step (b) to cover the whole first main side (102) of the silicon carbide layer (101).

11. The method according to any one of claim 8 to 10 wherein
the silicon carbide layer (101) provided in step (a) has plural active regions (AR1-AR4) and plural termination regions (TR1-TR4), each termination region (TR1-TR4) surrounding a corresponding one of the plural active regions (AR1-AR4) in an orthogonal projection onto a plane parallel to the first main side (101),
in step (b) the passivation material layer (200) is formed on the first main side (102) to cover at least a portion of each termination region (TR1-TR4),
in step (c) plural trenches (21) are formed in the passivation material layer (200), wherein each active region (AR1-AR4) is surrounded by at least one of the trenches (21) in the orthogonal projection onto the plane parallel to the first main side (102), and wherein a separation area (110) without the passivation layer (20) on the first main side (102) separates the plural termination regions (TR1-TR4) from each other, and
the method further comprises a step of dicing the silicon carbide layer (101) into plural silicon carbide dies after the step (c) along dicing lines (D) extending in the separation area (110).

12. The method according to claim 11, each active region (AR1-AR4) is surrounded by plural ring-shaped trenches (21) in the orthogonal projection onto the plane parallel to the first main side (102).

13. The method according to claim 12, wherein the plural trenches (21) surrounding each active region (AR1-AR4) separate the passivation layer (20) in plural rings (20a, 20b, 20c), wherein at least an outer side of each ring (20a, 20b, 20c) respectively surrounds a respective active region (AR1-AR4) in the orthogonal projection onto the plane parallel to the first main side (102), wherein an innermost ring (20a) of the passivation layer (20) surrounding the respective active region (AR1-AR4) has a larger lateral width (w1) than the lateral width (w2) of all other rings (20b, 20c) surrounding that respective active region (AR1-AR4), wherein the lateral width (w1, w2) of each ring (20a, 20b, 20c) is defined as a shortest lateral distance between an inner side and the outer side of the respective ring (20a, 20b, 20c) in the orthogonal projection onto the plane parallel to the first main side (102), wherein the outer side of any ring (20a, 20b, 20c) is the lateral side of that ring (20a, 20b, 20c) facing towards the respective active region (AR1-AR4) and the inner side of a ring (20a, 20b, 20c) is the lateral side of that ring (20a, 20b, 20c) facing away from the respective active region (AR1-AR4).

14. The method according to any one claims 8 to 13, wherein the method comprises a step of forming plural walls or pillars (210) of a polyimide material on the first main side (101) before the step (b) of forming the passivation material layer (200) on the first main side (101), wherein the passivation material layer (200) is formed in step (b) by a spin-on process, and wherein the walls or pillars are embedded into the passivation material layer (200) in the step (b) of forming the passivation material layer (200).

15. The method according to claim 14, wherein the walls or pillars are removed in the step (c) of patterning the passivation material layer (200).
